# EUROPÄISCHE PATENTSCHRIFT

(11) **EP 0 788 165 B1**
(45) Veröffentlichungstag und Bekanntmachung des Hinweises auf die Patenterteilung: **04.02.2004**
(21) Anmeldenummer: 96119225.9
(22) Anmeldetag: 29.11.1996
(51) Int. Cl.: H01L 27/112

(54) **Speicherzellenanordnung und Verfahren zu deren Herstellung**
Storage cell arrangement and method for making the same
Système de cellules de mémoire et son procédé de fabrication

(30) Priorität: 02.02.1996 DE 19603810
(43) Veröffentlichungstag der Anmeldung: 06.08.1997
(73) Patentinhaber: Infineon Technologies AG, 81669 München (DE)
(72) Erfinder: Rösner, Wolfgang, Dr., 81739 München (DE); Krautschneider, Wolfgang, Dr., 83104 Hohenthann (DE); Hofmann, Franz, Dr., 80995 München (DE)
(74) Vertreter: Epping Hermann & Fischer

(56) Entgegenhaltungen:
- DE-A- 4 214 923
- US-A- 4 954 854
- US-A- 5 306 941
- PATENT ABSTRACTS OF JAPAN vol. 095, no. 009, 31.Oktober 1995 & JP 07 142610 A (TOSHIBA CORP;OTHERS: 01), 2.Juni 1995,
- PATENT ABSTRACTS OF JAPAN vol. 015, no. 448 (E-1133), 14.November 1991 & JP 03 190165 A (SONY CORP), 20.August 1991,
- PATENT ABSTRACTS OF JAPAN vol. 014, no. 324 (E-0951), 11.Juli 1990 & JP 02 106966 A (SEIKO EPSON CORP), 19.April 1990,

## Beschreibung

Zur Abspeicherung großer Datenmengen, zum Beispiel für DV-Anwendungen oder zur digitalen Abspeicherung von Musik oder Bildern, werden derzeit hauptsächlich Speichersysteme mit mechanisch bewegten Teilen wie zum Beispiel Festplattenspeicher, Floppy-Disks oder Compact Disks verwendet. Die bewegten Teile sind mechanischem Verschleiß unterworfen. Ferner benötigen sie vergleichsweise viel Volumen und erlauben nur einen langsamen Datenzugriff. Da sie darüber hinaus erschütterungsund lageempfindlich sind und einen vergleichsweise hohen Energieverbrauch zu ihrem Betrieb haben, sind diese Speichersysteme in mobilen Systemen nur begrenzt einsetzbar.

Zur Speicherung kleinerer Datenmengen sind Festwertspeicher auf Halbleiterbasis bekannt. Vielfach werden diese als planare integrierte Siliziumschaltung realisiert, in der als Speicherzellen MOS-Transistoren verwendet werden. Die Transistoren werden über die Gateelektrode, die mit der Wortleitung verbunden ist, ausgewählt. Der Eingang des MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden die logischen Werte Null und Eins zugeordnet. Technisch wird die Speicherung von Null und Eins dadurch bewirkt, daß in Speicherzellen, in denen der dem Zustand "kein Stromfluß durch den Transistor" zugeordnete logische Wert gespeichert ist, kein MOS-Transistor hergestellt wird oder keine leitende Verbindung zur Bitleitung realisiert wird. Alternativ können für die beiden logischen Werte MOS-Transistoren realisiert werden, die durch unterschiedliche Implantationen im Kanalgebiet unterschiedliche Einsatzspannungen aufweisen.

Diese Speicher auf Halbleiterbasis erlauben einen wahlfreien Zugriff auf die gespeicherte Information. Die zum Lesen der Information erforderliche elektrische Leistung ist deutlich kleiner als bei den erwähnten Speichersystemen mit mechanisch bewegten Teilen. Da keine bewegten Teile erforderlich sind, entfällt hier auch der mechanische Verschleiß und die Empfindlichkeit gegenüber Erschütterungen. Speicher auf Halbleiterbasis sind daher auch für mobile Systeme einsetzbar.

Die beschriebenen Siliziumspeicher weisen einen planaren Aufbau auf. Damit wird pro Speicherzelle ein minimaler Flächenbedarf erforderlich, der im günstigsten Fall bei 4 F² liegt, wobei F die in der jeweiligen Technologie kleinste herstellbare Strukturgröße ist.

Aus US-PS 4 954 854 ist bekannt, in einem Festwertspeicher vertikale MOS-Transistoren zu verwenden. Dazu wird die Oberfläche eines Siliziumsubstrats mit Gräben versehen, an die am Boden ein Sourcegebiet angrenzt, an die an der Substratoberfläche ein Draingebiet angrenzt und entlang deren Flanken ein Kanalgebiet angeordnet ist. Die Oberfläche des Grabens wird mit einem Gatedielektrikum versehen und der Graben mit einer Gateelektrode aufgefüllt. Null und Eins werden in dieser Anordnung dadurch unterschieden, daß für einen der logischen Werte kein Graben geätzt und kein Transistor hergestellt wird.

Aus DE 42 14 923 A1 ist eine Festwertspeicherzellenanordnung bekannt, deren Speicherzellen MOS-Transistoren umfassen. Diese MOS-Transistoren sind entlang Gräben so angeordnet, daß ein Sourcegebiet an den Boden des Grabens angrenzt, ein Draingebiet an die Oberfläche des Substrats angrenzt und ein Kanalgebiet sowohl vertikal zur Oberfläche des Substrats als auch parallel zur Oberfläche des Substrats an Flanke und Boden des Grabens angrenzt. Die Oberfläche des Kanalgebietes ist mit einem Gatedielektrikum versehen. Die Gateelektrode ist als Flankenbedeckung (Spacer) ausgebildet. Die logischen Werte Null und Eins werden durch unterschiedliche Einsatzspannungen, die durch Kanalimplantation bewirkt werden, unterschieden. Bei der Kanalimplantation treffen die implantierenden Ionen unter einem solchen Winkel auf die Oberfläche des jeweiligen Grabens, daß durch Abschattungseffekte der gegenüberliegenden Flanke gezielt nur entlang einer Flanke implantiert wird.

In der US 5,306,941 ist eine Speicherzellenanordnung beschrieben, bei der an einer Hauptfläche eines Halbleitersubstrats eine Vielzahl von Speicherzellen mit je einem planaren MOS-Transistor vorgesehen sind, die in parallelen Zeilen, die abwechselnd am Boden von Gräben und an der Hauptfläche zwischen benachbarten Gräben verlaufen, angeordnet sind und mit einer Vielzahl von Wortleitungen verbunden sind, die quer zu den Gräben verlaufen und die mit Gateelektroden der planaren MOS-Transistoren verbunden sind.

In der JP 2-106966 A ist ein Halbleiterspeicher beschrieben, bei dem an den Wänden paralleler Gräben Kanalbereiche vorgesehen sind, an den Wänden längs der Gräben Wortleitungen angeordnet sind, die von den Kanalbereichen durch Gateoxid getrennt sind, und abwechselnd am Boden eines jeweiligen Grabens und an der Hauptfläche zwischen benachbarten Gräben n⁺-dotierte Diffusionsbereiche als Source/Drain vorgesehen sind.

Der Erfindung liegt das Problem zugrunde, eine Speicherzellenanordnung auf Halbleiterbasis anzugeben, bei der eine erhöhte Speicherdichte erzielt wird, so daß sie als Lesespeicher für große Datenmengen geeignet ist, und die mit wenigen Herstellungsschritten und hoher Ausbeute herstellbar ist. Desweiteren soll ein Verfahren zur Herstellung einer solchen Speicherzellenanordnung angegeben werden.

Dieses Problem wird erfindungsgemäß gelöst durch eine Speicherzellenanordnung gemäß Anspruch 1 sowie durch ein Verfahren zu deren Herstellung gemäß Anspruch 9. Weitere Ausgestaltungen der Erfindung ergeben sich aus den Unteransprüchen.

Die erfindungsgemäße Speicherzellenanordnung ist in einem Halbleitersubstrat realisiert. Als Halbleitersubstrat wird. vorzugsweise ein Substrat verwendet, das mindestens im Bereich einer Hauptfläche monokristallines Silizium aufweist. Als Halbleitersubstrat ist sowohl eine monokristalline Siliziumscheibe als auch ein SOI-Substrat geeignet.

Die Speicherzellenanordnung weist eine Vielzahl von Speicherzellen auf, die jeweils mindestens einen MOS-Transistor umfassen. Dabei umfassen erste Speicherzellen planare MOS-Transistoren, die in parallel verlaufenden Zeilen angeordnet sind. In der Hauptfläche des Halbleitersubstrats sind im wesentlichen parallel verlaufende, streifenförmige Gräben vorgesehen, die parallel zu den Zeilen verlaufen. Die Zeilen sind abwechselnd am Boden der Gräben und an der Hauptfläche zwischen benachbarten Gräben angeordnet.

Zweite Speicherzellen umfassen zur Hauptfläche vertikale MOS-Transistoren, die jeweils an den Seitenwänden der Gräben realisiert sind.

Die ersten Speicherzellen und die zweiten Speicherzellen unterscheiden sich bezüglich der technologischen Ausführung des MOS-Transistors. Bezüglich der Speichermöglichkeiten sind die ersten Speicherzellen und die zweiten Speicherzellen jedoch gleichwertig.

Es liegt im Rahmen der Erfindung, die Speicherzellenanordnung bei der Herstellung der Speicherzellenanordnung dadurch zu programmieren, daß die MOS-Transistoren mit unterschiedlichen Schwellenspannungen hergestellt werden. Dieses erfolgt vorzugsweise durch maskierte Kanalimplantation, bei der die Dotierung im Kanalbereich der MOS-Transistoren gezielt verändert wird.

Alternativ werden unterschiedliche Schwellenspannungen der MOS-Transistoren dadurch realisiert, daß die MOS-Transistoren, je nach eingespeicherter Information, unterschiedlich dicke Gatedielektrika aufweisen. Dabei wird ausgenutzt, daß bei einem Unterschied der Dicken der Gatedielektrika um einen Faktor von 10 oder mehr sich die Einsatzspannungen der MOS-Transistoren so deutlich unterscheiden, daß bei Anlegen eines Auswahlsignales mit einem Pegel zwischen beiden Einsatzspannungen der eine MOS-Transistor leitet und der mit dem dickeren Gatedielektrikum nicht leitet.

Soll die Speicherzellenanordnung für Mehrwertlogik eingesetzt werden, so weisen die MOS-Transistoren je nach eingespeicherter Information mehr als zwei unterschiedliche Schwellenspannungen auf.

Es liegt im Rahmen der Erfindung, für die MOS-Transistoren ein Gatedielektrikum aus einem Material mit Haftstellen vorzusehen. Haftstellen, englisch traps, haben die Eigenschaft, Ladungsträger, speziell Elektronen, einzufangen. Zur elektrischen Programmierung werden die MOS-Transistoren so beschaltet, daß der zu speichernden Information entsprechende Ladungsträger in das Gatedielektrikum gelangen und von den Haftstellen festgehalten werden.

Die Programmierung dieser Speicherzellenanordnung erfolgt nach der Herstellung durch Injektion von Elektronen. Dieses kann sowohl durch Fowler-Nordheim-Tunneln als auch durch Hot-Electron-Injection erfolgen. Zur Abspeicherung von Daten in digitaler Form werden die MOS-Transistoren so programmiert, daß sie zwei unterschiedliche Schwellenspannungen aufweisen. Soll die Speicherzellenanordnung für Mehrwertlogik eingesetzt werden, so wird das Gatedielektrikum durch entsprechende Spannungs- und Zeitbedingungen bei der Programmierung so mit unterschiedlichen Ladungsmengen beaufschlagt, daß die MOS-Transistoren je nach eingespeicherter Information mehr als zwei unterschiedliche Schwellenspannungen aufweisen.

Das Gatedielektrikum ist gemäß einer Ausführungsform der Erfindung als Mehrfachschicht ausgebildet, in der mindestens eine Schicht vorgesehen ist, die im Vergleich mit mindestens einer weiteren Schicht in der Mehrfachschicht einen erhöhten Ladungsträgereinfangquerschnitt aufweist. Die Haftstellen sind an der Grenzfläche zwischen beiden Schichten lokalisiert. Vorzugsweise umfaßt die dielektrische Mehrfachschicht eine SiO₂-Schicht, eine Si₃N₄-Schicht und eine SiO₂-Schicht (sogenanntes ONO). Alternativ kann das Gatedielektrikum als Mehrfachschicht aus anderen Materialien, wobei die Schicht mit dem erhöhten Ladungsträgereinfangquerschnitt zum Beispiel aus Si₃N₄, Ta₂O₅, Al₂O₃ oder aus TiO₂ besteht und die benachbarte Schicht aus SiO₂, Si₃N₄ oder Al₂O₃. Ferner kann die Mehrfachschicht mehr oder weniger als zwei Schichten umfassen.

Alternativ kann das Gatedielektrikum eine dielektrische Schicht, zum Beispiel aus SiO₂, umfassen, in die Fremdatome, zum Beispiel W, Pt, Cr, Ni, Pd, Si oder Ir eingelagert sind. Die eingelagerten Fremdatome können durch Implantation, durch Zugabe bei einer Oxidation oder durch Diffusion eingebracht werden. Die eingelagerten Fremdatome bilden in diesem Fall die Haftstellen.

In einer Zeile angeordnete planare MOS-Transistoren sind in Reihe verschaltet. Miteinander verbundene Source/Drain-Gebiete von entlang einer Zeile benachbarten planaren MOS-Transistoren sind dabei als zusammenhängendes, dotiertes Gebiet ausgebildet. Die beiden Source/Drain-Gebiete jedes der vertikalen MOS-Transistoren sind jeweils mit einem der Source/Drain-Gebiete eines der planaren MOS-Transistoren an der Hauptfläche des Substrats und mit einem der Source/Drain-Gebiete der planaren MOS-Transistoren am Boden der Gräben als zusammenhängendes dotiertes Gebiet ausgebildet.

Werden in dieser Ausführungsform die Gräben mit einer Breite F und einem Abstand F gebildet, wobei F die in der jeweiligen Technologie kleinste herstellbare Strukturgröße ist, und wird die Abmessung der Source/Drain-Gebiete und des Kanalgebiets der planaren MOS-Transistoren in Richtung der Zeilen jeweils entsprechend F gewählt, so sind auf einer Fläche von 2 F² eine erste Speicherzelle mit einem planaren MOS-Transistor und eine zweite Speicherzelle mit einem vertikalen MOS-Transistor angeordnet. Der mittlere Flächenbedarf pro Speicherzelle beträgt daher 1 F². Diese erhöhte Packungsdichte wird dadurch erzielt, daß die vertikalen MOS-Transistoren jeweils an den Seitenwänden der Gräben angeordnet sind und keine zusätzliche Fläche in der Projektion auf die Hauptfläche benötigen. Die entlang benachbarter Zeilen angeordneten planaren MOS-Transistoren sind durch das Kanalgebiet der an der jeweiligen Seitenwand angeordneten vertikalen MOS-Transistoren gegeneinander isoliert.

Gemäß der Erfindung sind eine Vielzahl erster Wortleitungen vorgesehen, die quer zu den Gräben verlaufen und die mit Gateelektroden von entlang unterschiedlichen Zeilen angeordneten planaren MOS-Transistoren verbunden sind. Ferner ist eine Vielzahl zweiter Wortleitungen vorgesehen, die jeweils paarweise in einem der Gräben angeordnet sind. Dabei sind die Gateelektroden von entlang einer der Seitenwände der Gräben angeordneten verikalen MOS-Transistoren mit einer der zweiten Wortleitungen verbunden. Zwischen je zwei benachbarten vertikalen MOS-Transistoren, die an derselben Seitenwand angeordnet sind, ist eine Isolationsstruktur vorgesehen, die die Ausbildung leitender Kanäle zwischen benachbarten MOS-Transistoren unterdrückt.

Die Isolationsstrukturen sind vorzugsweise als dotiertes Gebiet in der jeweiligen Seitenwand ausgebildet. Die Dotierstoffkonzentration in dem dotierten Gebiet ist dabei so hoch, daß bei Anliegen einer Spannung an der betreffenden Wortleitung der zwischen benachbarten MOS-Transistoren gebildete, parasitäre MOS-Transistor nicht leitet. Alternativ können die Isolationsstrukturen auch als isolierende Spacer, zum Beispiel aus SiO₂, gebildet werden.

Die Speicherzellenanordnung kann sowohl mit Enhancement-MOS-Transistoren als auch mit Depletion-MOS-Transistoren realisiert werden. Im Fall von Depletion-MOS-Transistoren werden jedoch im Hinblick auf eine wirksame Leckstromunterdrückung negative Ansteuerspannungen erforderlich. Bei Verwendung von Enhancement-MOS-Transistoren wird eine wirksame Leckstromunterdrückung auch bei Verwendung von positiven Ansteuerspannungen erzielt.

Die Herstellung der erfindungsgemäßen Speicherzellenanordnung erfolgt vorzugsweise unter Einsatz selbstjustierender Prozeßschritte, so daß der Platzbedarf pro Speicherzelle reduziert wird.

Zur Herstellung der Speicherzellenanordnung werden in der Hauptfläche des Halbleitersubstrats streifenförmige, parallel verlaufende Gräben geätzt. Die vertikalen MOS-Transistoren werden in den Seitenwänden der Gräben, die planaren MOS-Transistoren am Boden der Gräben und zwischen benachbarten Gräben an der Hauptfläche gebildet.

Es werden quer zu den Gräben verlaufende erste Wortleitungen gebildet. Bei einer nachfolgenden Implantation zur Bildung von Source/Drain-Gebieten für die planaren MOS-Transistoren und für die vertikalen MOS-Transistoren wirken die ersten Wortleitungen als Maske.

Vorzugsweise werden die zweiten Wortleitungen als Spacer aus zum Beispiel dotiertem Polysilizium an den Seitenwänden der Gräben gebildet. Zur Isolation zwischen den ersten Wortleitungen und den zweiten Wortleitungen wird die Oberfläche der zweiten Wortleitungen vor der Bildung der ersten Wortleitungen mit isolierendem Material bedeckt. Dieses erfolgt zum Beispiel durch thermische Oxidation der Oberfläche zum Beispiel bei der Bildung eines Gateoxids oder durch Bildung isolierender Spacer zum Beispiel aus SiO₂. Die Verwendung isolierender Spacer zur Isolation zwischen den ersten Wortleitungen und den zweiten Wortleitungen hat den Vorteil, daß die isolierenden Spacer in größerer Dicke und unabhängig von anderen Prozeßparametern wie zum Beispiel der Gateoxiddicke herstellbar sind.

Im folgenden wird die Erfindung anhand eines Beispiels und der Figuren näher erläutert. Die Darstellungen in den Figuren sind nicht maßstabsgetreu.
- Figur 1: zeigt ein Substrat nach einer ersten Kanalimplantation.
- Figur 2: zeigt das Substrat nach der Ätzung streifenförmiger Gräben.
- Figur 3: zeigt eine Aufsicht auf das Substrat nach Bildung einer ersten Maske und Erzeugung von Isolationsstrukturen in den Seitenwänden der Gräben.
- Figur 4: zeigt den in Figur 3 mit IV-IV bezeichneten Schnitt durch das Substrat.
- Figur 5: zeigt den in Figur 3 mit V-V bezeichneten Schnitt durch das Substrat. Dieser Schnitt entspricht dem in Figur 2 dargestellten Schnitt.
- Figur 6: zeigt den in Figur 4 gezeigten Schnitt durch das Substrat nach Bildung der Gatedielektrika und Gateelektroden für die vertikalen MOS-Transistoren.
- Figur 7: zeigt den in Figur 5 dargestellten Schnitt durch das Substrat nach Bildung isolierender Spacer, die die Gateelektroden der vertikalen MOS-Transistoren bedekken, nach Bildung der Gatedielektrika für die planaren MOS-Transistoren und nach Bildung von quer zu den Gräben verlaufenden ersten Wortleitungen.
- Figur 8: zeigt den Figur 6 entsprechenden Schnitt durch das Substrat nach Bildung von Source/Drain-Gebieten.
- Figur 9: zeigt eine Aufsicht auf das Substrat. Die in Figur 7 und Figur 8 dargestellten Schnitte sind in Figur 9 mit VII-VII bzw. VIII-VIII eingetragen.
- Figur 10: zeigt den Figur 8 entsprechenden Schnitt durch das Substrat nach Bildung von Bitleitungskontakten auf die am Boden der Gräben angeordneten Source/Drain-Gebiete.
- Figur 11: zeigt ein Schaltungsbild für eine Speicherzellenanordnung mit 3 x 3 Speicherzellenpaaren.

Zur Herstellung einer erfindungsgemäßen Speicherzellenanordnung wird in einem Substrat 1 aus zum Beispiel monokristallinem Silizium zunächst an einer Hauptfläche 2 des Substrats 1 ein Isolationsgebiet erzeugt, das ein Zellenfeld für die Speicherzellenanordnung definiert (nicht dargestellt). Das Isolationsgebiet wird zum Beispiel durch einen LOCOS-Prozeß oder einen STI (Shallow Trench Isolation)-Prozeß gebildet. Das Substrat 1 ist zum Beispiel p-dotiert mit einer Dotierstoffkonzentration von 10¹⁵ cm⁻³.

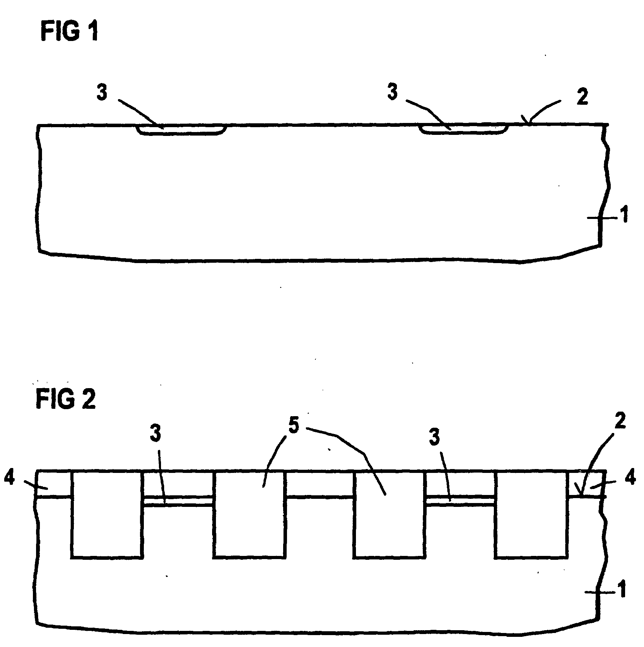

Mit Hilfe eines photolithographischen Verfahrens werden dann Bereiche für Depletion-Kanäle von MOS-Transistoren definiert. Mit Hilfe einer ersten Kanalimplantation mit Arsen mit einer Energie von zum Beispiel 40 keV und einer Dosis von 4 x 10¹³ cm⁻² werden die Depletion-Kanäle 3 gebildet. Die Ausdehnung der Depletion-Kanäle 3 parallel zur Hauptfläche 2 beträgt 2 F x 2 F, das heißt bei Verwendung einer 0,4 µm-Technologie zum Beispiel 0,8 µm x 0,8 µm (siehe Figur 1).

Durch Abscheidung einer SiO₂-Schicht in einer Dicke von zum Beispiel 100 nm bis 200 nm mit Hilfe eines TEOS-Verfahrens und anschließende Strukturierung der SiO₂-Schicht mit Hilfe photolithographischer Verfahren wird eine Grabenmaske 4 gebildet (siehe Figur 2).

Durch anisotropes Ätzen zum Beispiel mit Cl₂ werden unter Verwendung der Grabenmaske 4 als Ätzmaske streifenförmige Gräben 5 geätzt. Die Gräben 5 weisen eine Tiefe von zum Beispiel 0,5 µm auf . Die Weite der Gräben 5 beträgt F, zum Beispiel 0,4 µm, der Abstand benachbarter Gräben 5 beträgt ebenfalls F, zum Beispiel 0,4 µm. Die Länge der Gräben 5 richtet sich nach der Größe der Speicherzellenanordnung und beträgt zum Beispiel 130 µm.

Die Breite der Depletion-Kanäle 3 wird bei der Ätzung der Gräben 5 auf den Abstand der Gräben 5 eingestellt. Daher ist die Justierung der Grabenmaske 4 relativ zu den Depletion-Kanälen 3 unkritisch.

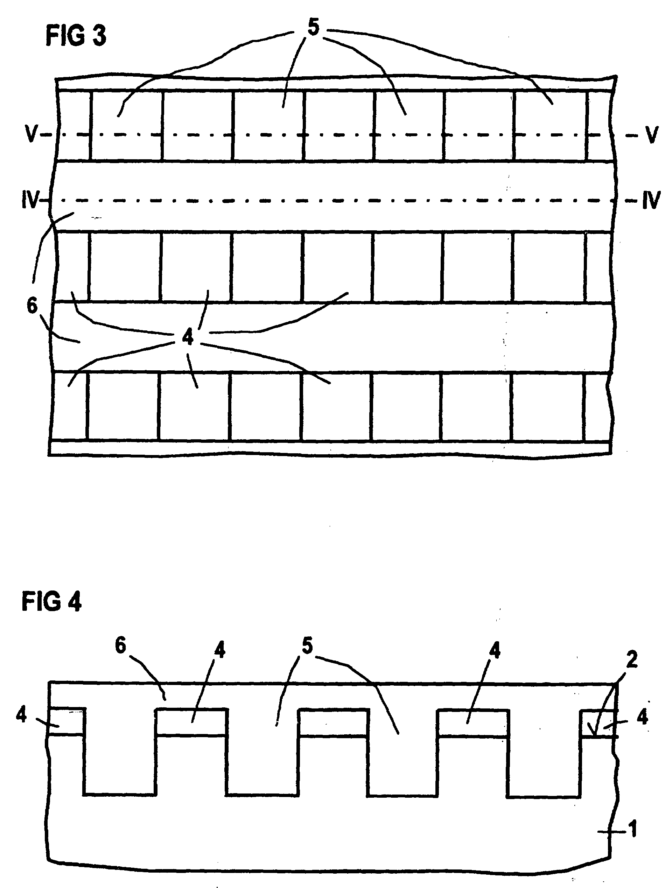

Anschließend wird mit Hilfe photolithographischer Prozeßschritte eine erste Lackmaske 6 gebildet (siehe Figur 3, Figur 4, Figur 5). Die erste Lackmaske 6 weist streifenförmige Öffnungen auf, die senkrecht zu den Gräben 5 verlaufen (siehe Aufsicht in Figur 3). Die Weite der Öffnungen beträgt F, zum Beispiel 0,4 µm, der Abstand benachbarter Öffnungen beträgt ebenfalls F, zum Beispiel 0,4 µm. Im Bereich der Öffnungen der ersten Lackmaske 6 werden an den Seitenwänden der Gräben 5 Isolationsstrukturen 7 erzeugt. Die Isolationsstrukturen 7 werden zum Beispiel durch eine gewinkelte Implantation mit Borionen gebildet. Der Winkel bei der Ionenimplantation wird so gewählt, daß nur die Seitenwände innerhalb des Implantationsstrahles liegen und der Boden der Gräben 5 abgeschattet wird. Die Implantation wird dabei von zwei Seiten durchgeführt, so daß an beiden Seitenwänden Isolationsstrukturen 7 gebildet werden. Die Implantation erfolgt zum Beispiel mit Borionen unter einem Winkel von 15°, mit einer Energie von zum Beispiel 25 keV und einer Dosis von 10¹⁴ cm⁻².

Alternativ können die Isolationsstrukturen 7 durch Ausdiffusion aus Spacern, die als Diffusionsquelle geeignet sind, gebildet werden. Die Spacer werden zum Beispiel aus bordotiertem Glas durch Abscheidung einer bordotierten Glasschicht und anisotropes Rückätzen an den Seitenwänden der Gräben 5 erzeugt. Anschließend werden sie mit Hilfe einer Lackmaske so strukturiert, daß sie nur an den Bereichen der Seitenwand stehenbleiben, an denen Isolationsstrukturen 7 gebildet werden sollen. Die zur Strukturierung verwendete Lackmaske weist streifenförmige Öffnungen auf, die komplementär zu den Öffnungen der ersten Lackmaske 6 sind.

In einer weiteren Alternative können die Isolationsstrukturen 7 in Form von isolierenden Spacern gebildet werden. Dazu wird zum Beispiel in einem TEOS-Verfahren eine SiO₂-Schicht in einer Schichtdicke von zum Beispiel 30 bis 80 nm abgeschieden und anisotrop zurückgeätzt. Mit Hilfe einer Lackmaske, die zu der ersten Lackmaske 6 komplementär ist, werden die Spacer so strukturiert, daß die Isolationsstrukturen 7 entstehen.

Nach Entfernen der ersten Lackmaske 6 wird eine zweite Lackmaske (nicht dargestellt) gebildet. Es wird eine zweite Kanalimplantation durchgeführt, bei der durch eine geneigte Implantation von zum Beispiel Bor mit einer Energie von 25 keV und einer Dosis von zum Beispiel 5 x 10 ¹² cm⁻² in den Seitenwänden der Gräben eine höhere Schwellenspannung erzeugt wird (nicht dargestellt). In diesem Prozeßschritt erfolgt die Programmierung der vertikalen MOS-Transistoren.

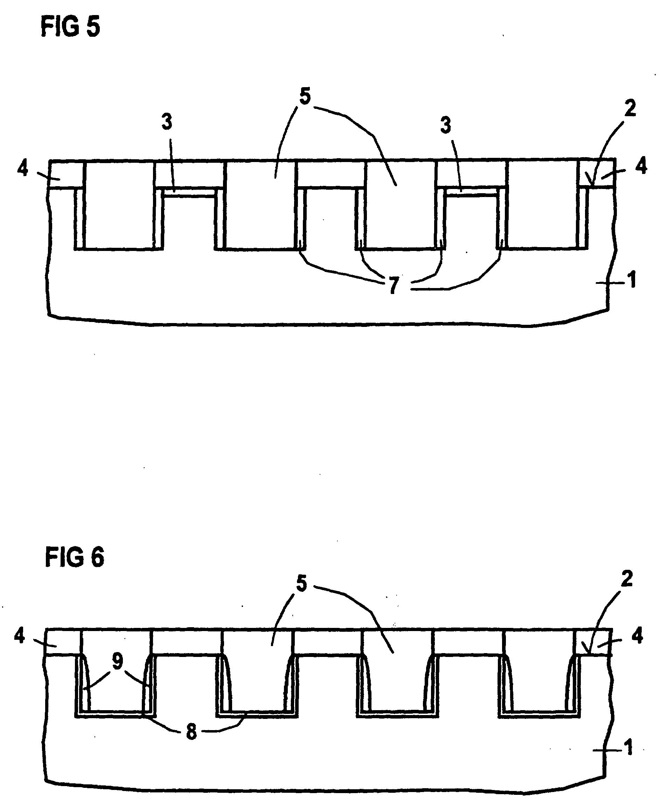

Nachfolgend wird an den Seitenwänden der Gräben 5 ein Gatedielektrikum 8 zum Beispiel aus thermischem SiO₂ in einer Schichtdicke von zum Beispiel 5 bis 10 nm gebildet (siehe Figur 6).

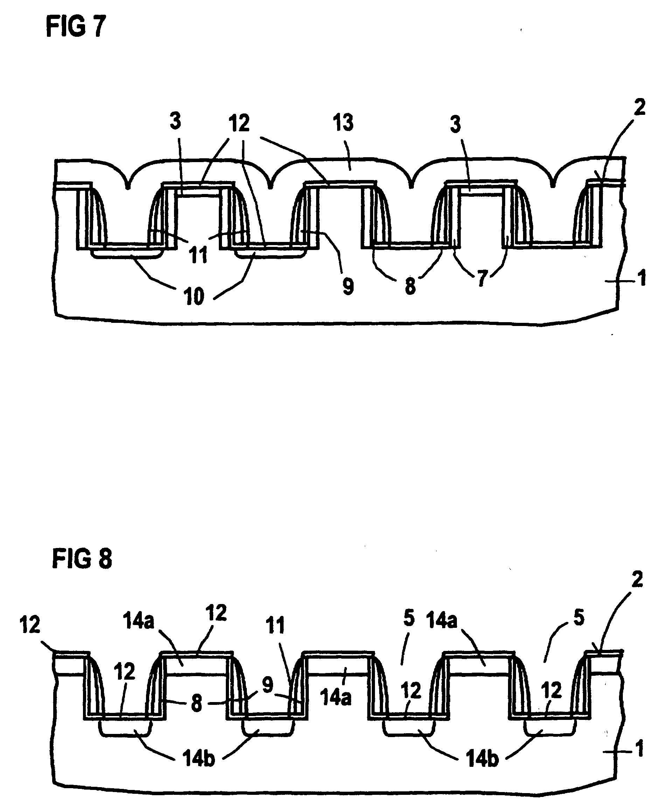

Es wird ganzflächig eine dotierte Polysiliziumschicht mit konformer Kantenbedeckung und einer Dicke von zum Beispiel 50 nm gebildet. Die dotierte Polysiliziumschicht ist zum Beispiel n⁺-dotiert. Sie wird durch insitu-dotierte Abscheidung oder durch undotierte Abscheidung und anschließende Dotierung durch Diffusion oder Implantation erzeugt. Durch anisotropes Rückätzen der dotierten Polysiliziumschicht werden an den Seitenwänden der Gräben 5 dotierte Polysiliziumspacer 9 gebildet. Diese Ätzung wird selektiv zum Gatedielektrikum durchgeführt. Die dotierten Polysiliziumspacer 9 verlaufen an den Seitenwänden der Gräben 5 über die gesamte Länge der Gräben 5 (siehe Figur 6 und Figur 7). Zur Reduktion des Schichtwiderstands der dotierten Polysiliziumspacer 9 ist es vorteilhaft, diese mit einer dünnen Metallsilizidschicht zu versehen. Die Metallsilizidschicht wird zum Beispiel durch Reaktion mit Wolfram gebildet. Dabei wird ausgenutzt, daß sich das Wolframsilizid nur auf dem Polysilizium ausbildet, nicht aber auf den von Gatedielektrikum bedeckten Grabenböden und Stegen.

Unter Verwendung einer dritten Lackmaske (nicht dargestellt) wird eine dritte Kanalimplantation durchgeführt. Dabei werden am Boden der Gräben 5 Depletion-Kanäle 10 gebildet. Anschließend wird die dritte Lackmaske wieder entfernt.

Anschließend wird die Grabenmaske 4 durch naßchemisches Ätzen zum Beispiel mit Flußsäure entfernt. Dabei werden auch am Boden der Gräben 5 befindliche Anteile des Gatedielektrikums 8 entfernt. Durch ganzflächige Abscheidung zum Beispiel in einem TEOS-Verfahren und anschließendes, anisotropes Rückätzen einer SiO₂-Schicht werden isolierende Spacer 11 gebildet, die die dotierten Polysiliziumspacer 9 vollständig abdecken (siehe Figur 7 und Figur 8). Die SiO₂-Schicht wird in einer Schichtdicke von zum Beispiel 30 bis 80 nm abgeschieden.

Nachfolgend wird ein weiteres Gatedielektrikum 12 zum Beispiel aus thermischem SiO₂ gebildet. Das weitere Gatedielektrikum 12 ist am Boden der Gräben 5 und an der Hauptfläche 2 zwischen benachbarten Gräben 5 angeordnet. Es weist eine Schichtdicke von zum Beispiel 5 bis 10 nm auf.

Anschließend wird eine Polysiliziumschicht und eine SiO₂-Schicht abgeschieden. Die Polysiliziumschicht wird zum Beispiel insitu dotiert abgeschieden oder undotiert abgeschieden und anschließend durch Implantation oder Diffusion zum Beispiel aus der Gasphase dotiert. Die SiO₂-Schicht wird zum Beispiel in einem TEOS-Verfahren abgeschieden. Mit Hilfe photolithographischer Verfahren wird aus der SiO₂-Schicht eine Hartmaske gebildet (nicht dargestellt). Unter Verwendung der Hartmaske als Ätzmaske wird die dotierte Polysiliziumschicht strukturiert. Dabei werden quer zu den Gräben 5 verlaufende erste Wortleitungen 13 erzeugt (siehe Figur 7). Die Strukturierung der ersten Wortleitungen 13 erfolgt hochselektiv gegen das weitere Gatedielektrikum 12. Vorzugsweise erfolgt diese Strukturierung unter Verwendung eines trockenen Ätzprozesses mit HBr und Cl₂.

Die ersten Wortleitungen 13 werden so angeordnet, daß sie jeweils oberhalb der Isolationsstrukturen 7 verlaufen. Zur Herstellung der ersten Wortleitungen 13 ist daher eine Justierung bezüglich der Isolationsstrukturen 7 erforderlich.

Nachfolgend wird eine Implantation mit Arsen bei einer Energie von zum Beispiel 80 keV und einer Dosis von zum Beispiel 5 x 10¹⁵ cm⁻² durchgeführt, bei der Source/Drain-Gebiete 14a an der Hauptfläche 2 und Source/Drain-Gebiete 14b am Boden der Gräben 5 gebildet werden. Die Source/Drain-Gebiete 14a, 14b weisen eine Tiefe von jeweils 100 nm auf (siehe Figur 8). Nach Bildung der Source-/Drain-Gebiete 14a, 14b wird die Hartmaske entfernt.

Je zwei Source/Drain-Gebiete 14a an der Hauptfläche 2 und der dazwischen an die Hauptfläche 2 angrenzende Teil des p-dotierten Substrats 1 mit oder ohne Depletion-Kanal 3 sowie das darüber angeordnete weitere Gatedielektrikum 12 und der darüber angeordnete Teil der jeweiligen ersten Wortleitung 13 bilden jeweils einen planaren MOS-Transistor. Ebenso bilden je zwei am Boden der Gräben 5 angeordnete Source/Drain-Gebiete 14b sowie der dazwischen an den Boden des Grabens 5 angeordnete Teil des p-dotierten Substrats 1 mit oder ohne Depletion-Kanal 10 sowie das darüber angeordnete weitere Gatedielektrikum 12 und der darüber angeordnete Teil der jeweiligen ersten Wortleitung 13 einen am Boden des Grabens 5 angeordneten, planaren MOS-Transistor. Je zwei an eine Seitenwand des Grabens 5 angrenzende Source/Drain-Gebiete 14a, 14b sowie der dazwischen an die Seitenwand angrenzende Teil des p-dotierten Substrats 1 mit oder ohne Depletion-Kanal bilden mit dem daran angrenzenden Teil des Gatedielektrikums 8 sowie der dotierten Polysiliziumspacer 9 einen vertikalen MOS-Transistor. Benachbarte planare MOS-Transistoren, die am Boden eines Grabens 5 und an der Hauptfläche angeordnet sind, sind durch das p-dotierte Substrat 1 gegeneinander isoliert. Die dotierten Polysiliziumspacer 9 bilden zweite Wortleitungen, über die die vertikalen MOS-Transistoren angesteuert werden. Die dotierten Polysiliziumspacer 9 sind gegen die ersten Wortleitungen 13 durch die isolierenden Spacer 11 isoliert.

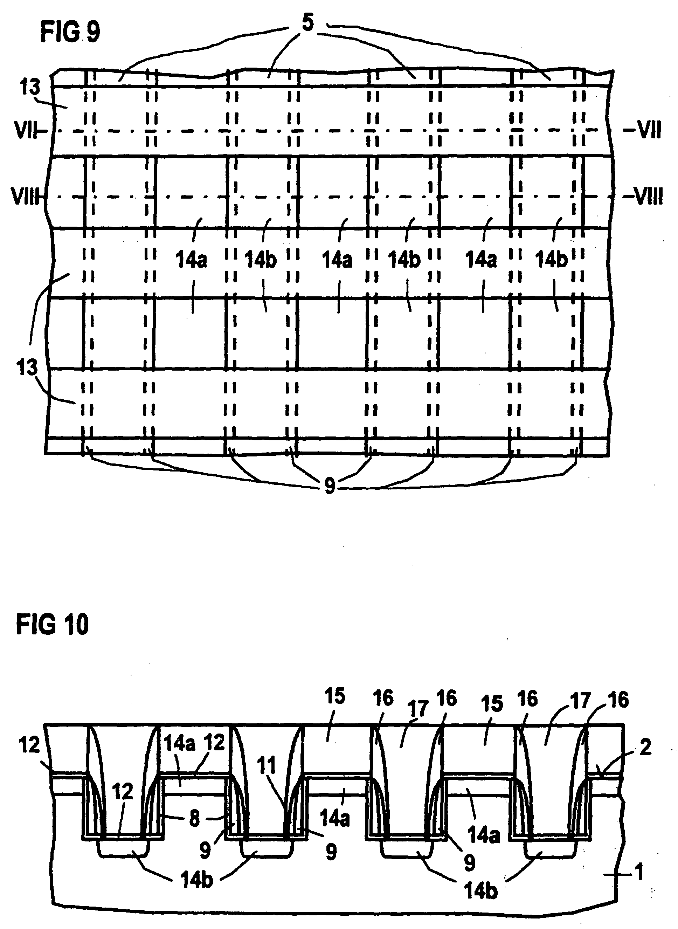

In Figur 9 ist eine Aufsicht auf die in Figur 7 und 8 dargestellten Schnitte dargestellt. In diese Aufsicht wurden als gestrichelte Linien die Lage der dotierten Polysiliziumspacer 9 eingetragen. Die ersten Wortleitungen 13 und die dotierten Polysiliziumspacer 9, die die zweiten Wortleitungen bilden, verlaufen senkrecht zueinander.

In dem Ausführungsbeispiel weisen die Source/Drain-Gebiete 14a, 14b parallel zur Hauptfläche 2 Abmessungen von F x F auf. Sie sind unmittelbar nebeneinander angeordnet (siehe Figur 9). Der Abstand zwischen benachbarten Source/Drain-Gebieten 14a, 14b parallel zu den Gräben 5 beträgt ebenfalls F. Jedes Source/Drain-Gebiet 14a, 14b gehört zwei benachbarten planaren MOS-Transistoren an. Die vertikalen MOS-Transistoren sind in den Seitenwänden der Gräben 5 realisiert und benötigen parallel zur Hauptfläche 2 keine Fläche. Daher beträgt der Flächenbedarf für zwei Speicherzellen, die einen planaren MOS-Transistor und einen vertikalen MOS-Transistor umfassen, 2 F². Der mittlere Flächenbedarf pro Speicherzelle beträgt daher F².

Zur Fertigstellung der Speicherzellenanordnung wird ganzflächig eine Zwischenoxidschicht 15 erzeugt (siehe Figur 10). Die Zwischenoxidschicht 15 wird in einer Schichtdicke von zum Beispiel 1600 nm gebildet. In der Zwischenoxidschicht 15 werden Kontaktlöcher zu am Boden der Gräben 5 befindlichen Source/Drain-Gebieten 14b geöffnet. Zur Vermeidung von Kurzschlüssen werden die Seitenwände der Kontaktlöcher mit isolierenden Spacern 16 versehen. Die isolierenden Spacer 16 werden zum Beispiel durch Abscheidung einer SiO₂-Schicht in einem TEOS-Verfahren in einer Schichtdicke von zum Beispiel 30 bis 80 nm und anisotropes Rückätzen der SiO₂-Schicht gebildet. Durch die Spacer 16 werden möglicherweise infolge von Justierfehlern freigeätzte Teile der an der Hauptfläche 2 befindlichen Source/Drain-Gebiete 14a oder der Wortleitungen 13 abgedeckt. Die Kontaktlöcher werden schließlich mit Metallfüllungen 17 aufgefüllt. Dazu wird zum Beispiel eine Metallschicht durch Sputtern oder Aufdampfen aufgebracht und mit Hilfe photolithographischer Prozeßschritte sowie einem Ätzschritt strukturiert. Die Metallfüllungen 17 werden zum Beispiel aus Aluminium oder Wolfram gebildet.

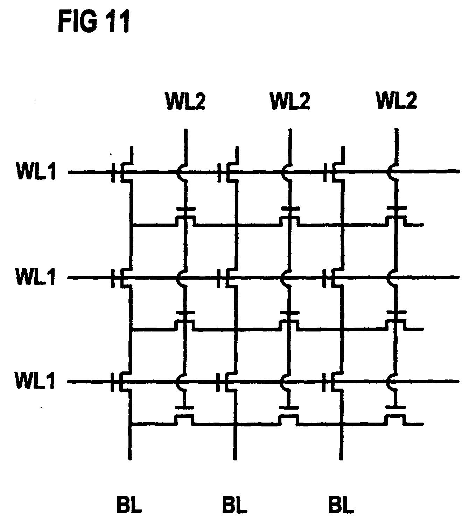

In Figur 11 ist ein Schaltbild für ein Speicherzellenfeld mit 3 x 3 Speicherzellenpaaren dargestellt. Die einzelnen Speicherzellen sind in einer NAND-Konfiguration angeordnet. Mit WL1 sind die ersten Wortleitungen 13 bezeichnet, die jeweils Gateelektroden von planaren MOS-Transistoren miteinander verbinden. Mit WL2 sind die zweiten Wortleitungen, die durch die dotierten Polysiliziumspacer 9 gebildet werden, bezeichnet, die jeweils Gateelektroden von vertikalen MOS-Transistoren miteinander verbinden. Mit BL sind die Bitleitungen bezeichnet, die durch die jeweils in Reihe verschalteten planaren MOS-Transistoren, die an der Hauptfläche 2 sowie am Boden der Gräben 5 angeordnet sind, realisiert sind. Die Bewertung der planaren MOS-Transistoren erfolgt über die Bitleitungen BL und die jeweiligen ersten Wortleitungen WL1. Die Bewertung der vertikalen MOS-Transistoren erfolgt jeweils zwischen einer benachbarten Bitleitung BL von planaren MOS-Transistoren, die an der Hauptfläche 2 angeordnet sind und dem am Boden des Grabens 5 angeordneten Source/Drain-Gebiet 14b, das über die Metallfüllung 17 auf ein Referenzpotential gelegt wird.

In der beschriebenen Ausführungsform der Erfindung erfolgt die Programmierung der Speicherzellenanordnung bei der Herstellung der Speicherzellenanordnung durch die erste Kanalimplantation, die zweite Kanalimplantation und die dritte Kanalimplantation. Die dabei gespeicherte Information wird über die Anordnung der Öffnungen in den bei den Kanalimplantationen verwendeten Lackmasken eingebracht.

Die zweite Kanalimplantation zur Programmierung der vertikalen MOS-Transistoren kann alternativ nach der Herstellung der ersten Wortleitungen 13 erfolgen. Die zweite Lackmaske wird in diesem Fall oberhalb der Hartmaske, die zur Strukturierung der ersten Wortleitungen 13 verwendet wird, erzeugt. Die Öffnungen überlappen die Hartmaske, so daß die Justierung der zweiten Lackmaske parallel zum Verlauf der Gräben unkritisch ist. Die Depletion-Kanäle in den Seitenwänden der Gräben werden auch in diesem Fall durch schräge Implantation von Bor gebildet. Die Energie bei der Ionenimplantation wird dabei so eingestellt, daß die Borionen durch die dotierten Polysiliziumspacer 9 und das Gatedielektrikum 8 hindurch in die Seitenwand der Gräben 5 gelangen. Die Implantation erfolgt zum Beispiel mit einer Energie von 50 keV.

Unterschiedliche Schwellenspannungen der MOS-Transistoren können bei der Herstellung auch durch Bildung unterschiedlich dicker Gatedielektrika der planaren und/oder vertikalen MOS-Transistoren realisiert werden.

In einer weiteren Alternative wird als Gatedielektrikum 8 und als weiteres Gatedielektrikum 12 ein Material mit Haftstellen verwendet. Das Gatedielektrikum 8 und das weitere Gatedielektrikum 12 werden zum Beispiel aus einer dielektrischen Mehrfachschicht gebildet, in der mindestens eine Schicht vorgesehen ist, die im Vergleich mit mindestens einer weiteren Schicht in der Mehrfachschicht einen erhöhten Ladungsträgereinfangquerschnitt aufweist. Vorzugsweise umfaßt die dielektrische Mehrfachschicht eine SiO₂-Schicht, eine Si₃N₄-Schicht und eine SiO₂-Schicht (sogenanntes ONO). Die Schichtdicken in der Mehrfachschicht werden dabei so bemessen, daß die Mehrfachschicht bezüglich der Gatekapazität einer Schicht aus thermischem SiO mit einer Dicke von zum Beispiel 10 nm entspricht. Dazu sind für die SiO₂-Schichten Schichtdicken von jeweils 4 nm und für die Si₃N₄-Schicht eine Schichtdicke von 4 nm erforderlich.

Werden das Gatedielektrikum 8 und das weitere Gatedielektrikum 12 aus einem Material mit hoher Haftstellendichte gebildet, so erfolgt die Programmierung der Speicherzellenanordnung nach deren Herstellung durch Injektion von Ladungsträgern, speziell Elektronen, in das Gatedielektrikum 8 bzw. das weitere Gatedielektrikum 12. Die Ladungsträger können durch Fowler-Nordheim-Tunneln oder Hot-Electron-Injection eingebracht werden. In diesem Fall entfallen die erste Kanalimplantation, die zweite Kanalimplantation und die dritte Kanalimplantation sowie die dabei verwendeten Lackmasken.

Im Hinblick auf eine wirksame Leckstromunterdrückung zwischen den Speicherzellen ist es vorteilhaft, für die planaren MOS-Transistoren und die vertikalen MOS-Transistoren Enhancement-Transistoren zu verwenden. Zur Realisierung der Informationszustände "Eins" und "Null" werden die unterschiedlichen Schwellenspannungen zum Beispiel auf 0,5 Volt und 1,5 Volt eingestellt.

## Patentansprüche

1. Speicherzellenanordnung, bei der
- an einer Hauptfläche (2) eines Halbleitersubstrats (1) eine Vielzahl von Speicherzellen vorgesehen sind, die jeweils mindestens einen MOS-Transistor umfassen,
- erste Speicherzellen planare MOS-Transistoren umfassen, die in parallel verlaufenden Zeilen angeordnet sind,
- in dem Halbleitersubstrat (1) im wesentlichen parallel verlaufende, streifenförmige Gräben (5) vorgesehen sind, die parallel zu den Zeilen verlaufen,
- die Zeilen abwechselnd am Boden der Gräben (5) und an der Hauptfläche (2) zwischen benachbarten Gräben (5) angeordnet sind und
- eine Vielzahl erster Wortleitungen (13) vorgesehen ist, die quer zu den Gräben (5) verlaufen und die mit Gateelektroden von planaren MOS-Transistoren verbunden sind,
**dadurch gekennzeichnet, dass**
- in einer Zeile angeordnete planare MOS-Transistoren in Reihe verschaltet sind,
- die miteinander verbundenen Source/Drain-Gebiete (14a, 14b) von entlang einer Zeile benachbarten planaren MOS-Transistoren als zusammenhängendes dotiertes Gebiet ausgebildet sind,
- zweite Speicherzellen zur Hauptfläche (2) vertikale MOS-Transistoren umfassen, die jeweils an den Seitenwänden der Gräben (5) realisiert sind,
- die beiden Source/Drain-Gebiete (14a, 14b) der vertikalen MOS-Transistoren jeweils mit einem der Source/Drain-Gebiete (14a) eines der planaren MOS-Transistoren an der Hauptfläche (2) des Halbleitersubstrats (1) und mit einem der Source/Drain-Gebiete (14b) der planaren MOS-Transistoren am Boden der Gräben (5) als zusammenhängendes dotiertes Gebiet ausgebildet sind,
- eine Vielzahl zweiter Wortleitungen (9) vorgesehen sind, die jeweils paarweise in einem der Gräben (5) angeordnet sind,
- die Gateelektroden der entlang einer der Seitenwände der Gräben (5) angeordneten vertikalen MOS-Transistoren mit einer der zweiten Wortleitungen (9) verbunden sind und
- zwischen je zwei benachbarten vertikalen MOS-Transistoren, die an derselben Seitenwand angeordnet sind, eine Isolationsstruktur (7) vorgesehen ist, die die Ausbildung leitender Kanäle zwischen benachbarten MOS-Transistoren unterdrückt.

2. Speicherzellenanordnung nach Anspruch 1, bei der die Isolationsstrukturen (7) jeweils als dotiertes Gebiet in der jeweiligen Seitenwand ausgebildet sind.

3. Speicherzellenanordnung nach Anspruch 1 oder 2, bei der die MOS-Transistoren je nach in der jeweiligen Speicherzelle eingespeicherter Information unterschiedliche Schwellenspannungen aufweisen.

4. Speicherzellenanordnung nach Anspruch 1 oder 2, bei der die MOS-Transistoren ein Gatedielektrikum (8, 12) aus einem Material mit Haftstellen aufweisen.

5. Speicherzellenanordnung nach Anspruch 4, bei der die MOS-Transistoren als Gatedielektrikum (8, 12) eine dielektrische Mehrfachschicht umfassen mit mindestens einer Schicht, die im Vergleich mit mindestens einer weiteren Schicht einen erhöhten Ladungsträgereinfangquerschnitt aufweist.

6. Speicherzellenanordnung nach Anspruch 5, bei der die Schicht mit erhöhtem Ladungsträgereinfangquerschnitt mindestens einen der Stoffe Si₃N₄, Ta₂O₅, Al₂O₃, oder TiO₂ umfaßt und die weitere Schicht mindestens einen der Stoffe SiO₂, Si₃N₄ oder Al₂O₂ umfaßt.

7. Speicherzellenanordnung nach Anspruch 4, bei der die MOS-Transistoren als Gatedielektrikum (8, 12) eine dielektrische Schicht mit eingelagerten Fremdatomen umfassen, wobei die eingelagerten Fremdatome im Vergleich mit der dielektrischen Schicht einen erhöhten Ladungsträgereinfangquerschnitt aufweisen.

8. Speicherzellenanordnung nach Anspruch 7, bei der die dielektrische Schicht SiO₂ umfaßt und die eingelagerten Fremdatome mindestens eines der Elemente W, Pt, Cr, Ni, Pd, Si oder Ir enthalten.

9. Verfahren zur Herstellung einer Speicherzellenanordnung, bei dem
- in einer Hauptfläche (2) eines Halbleitersubstrats (1) mehrere im wesentlichen parallel verlaufende, streifenförmige Gräben (5) geätzt werden und
- jeweils am Boden der Gräben (5) und an der Hauptfläche (2) zwischen benachbarten Gräben (5) planare MOS-Transistoren gebildet werden,
**dadurch gekennzeichnet, dass**
- die am Boden der Gräben (5) sowie an der Hauptfläche zwischen benachbarten Gräben (5) angeordneten planaren MOS-Transistoren jeweils in Reihe verschaltet werden, indem die Source/Drain-Gebiete (14a, 14b) benachbarter planarer MOS-Transistoren jeweils als zusammenhängendes dotiertes Gebiet ausgebildet werden,
- an den Seitenwänden der Gräben (5) vertikale MOS-Transistoren gebildet werden,
- die beiden Source/Drain-Gebiete (14a, 14b) jedes vertikalen MOS-Transistors jeweils mit einem der Source/Drain-Gebiete (14a) eines der planaren MOS-Transistoren an der Hauptfläche (2) des Substrats (1) und mit einem der Source/Drain-Gebiete (14b) der planaren MOS-Transistoren am Boden der Gräben (5) als zusammenhängendes Gebiet ausgebildet werden. und
- zwischen je zwei benachbarten vertikalen MOS-Transistoren, die an derselben Seitenwand angeordnet sind, eine Isolationsstruktur (7) gebildet wird, die die Ausbildung leitender Kanäle zwischen benachbarten MOS-Transistoren unterdrückt.

10. Verfahren nach Anspruch 9, bei dem
zur Bildung der Isolationsstruktur (7) in der jeweiligen Seitenwand jeweils dotierte Gebiete gebildet werden.

11. Verfahren nach Anspruch 9 oder 10, bei dem
nach Bildung eines Gatedielektrikums (12) für die planaren MOS-Transistoren mehrere erste wortleitungen (13) gebildet werden, die quer zu den Gräben (5) verlaufen und die die Gateelektroden der planaren MOS-Transistoren umfassen, und eine Ionenimplantation zur Bildung der Source/Drain-Gebiete (14a, 14b) durchgeführt wird, wobei die ersten Wortleitungen (13) maskierend wirken.

12. Verfahren nach einem der Ansprüche 9 bis 11, bei dem nach Bildung eines Gatedielektrikums (8) für die vertikalen MOS-Transistoren durch Bildung einer leitfähigen Schicht mit im wesentlichen konformer Kantenbedeckung und anisotropes Rückätzen der leitfähigen Schicht in jedem Graben (5) zweite Wortleitungen gebildet werden, die jeweils entlang einer Seitenwand des Grabens (5) angeordnet sind und die die Gateelektroden der entlang dieser Seitenwand angeordneten vertikalen MOS-Transistoren umfassen.

13. Verfahren nach einem der Ansprüche 9 bis 12, bei dem die MOS-Transistoren je nach eingespeicherter Information mit unterschiedlichen Schwellenspannungen hergestellt werden.

14. Verfahren nach einem der Ansprüche 9 bis 12, bei dem das Gatedielektrikum (8, 12) der MOS-Transistoren aus einem Material mit Haftstellen gebildet wird.

15. Verfahren nach Anspruch 14, bei dem
das Gatedielektrikum (8, 12) als dielektrische Mehrfachschicht mit mindestens einer Schicht, die im Vergleich mit mindestens einer weiteren Schicht einen erhöhten Ladungsträgereinfangquerschnitt aufweist, gebildet wird.

16. Verfahren nach Anspruch 14, bei dem
das Gatedielektrikum (8, 12) als dielektrische Schicht mit eingelagerten Fremdatomen gebildet wird, wobei die eingelagerten Fremdatome im Vergleich mit der dielektrischen Schicht einen erhöhten Ladungsträgereinfangquerschnitt aufweisen.

## Claims

1. Memory cell arrangement, in which
- a multiplicity of memory cells are provided on a main area (2) of a semiconductor substrate (1), which memory cells each comprise at least one MOS transistor,
- first memory cells comprise planar MOS transistors arranged in rows which run in parallel,
- strip-like trenches (5) which essentially run in parallel and run parallel to the rows are provided in the semiconductor substrate (1),
- the rows are arranged alternately on the bottom of the trenches (5) and on the main area (2) between adjacent trenches (5), and
- a multiplicity of first word lines (13) are provided which run transversely with respect to the trenches (5) and are connected to gate electrodes of planar MOS transistors, charaterized in that
- planar MOS transistors arranged in a row are interconnected in series,
- the interconnected source/drain regions (14a, 14b) of planar MOS transistors which are adjacent along a row are formed as a coherent, doped region,
- second memory cells comprise MOS transistors which are vertical with respect to the main area (2) and are each realized on the side walls of the trenches (5),
- the two source/drain regions (14a, 14b) of the vertical MOS transistors are in each case formed as a coherent, doped region with one of the source/drain regions (14a) of one of the planar MOS transistors on the main area (2) of the semiconductor substrate (1) and with one of the source/drain regions (14b) of the planar MOS transistors on the bottom of the trenches (5),
- a multiplicity of second word lines (9) are provided which are each arranged in pairs in one of the trenches (5),
- the gate electrodes of the vertical MOS transistors arranged along one of the side walls of the trenches (5) are connected to one of the second word lines (9), and
- an insulation structure (7), which suppresses the formation of conductive channels between adjacent MOS transistors, is provided between each two adjacent vertical MOS transistors which are arranged on the same side wall.

2. Memory cell arrangement according to Claim 1, in which
the insulation structures (7) are each designed as a doped region in the respective side wall.

3. Memory cell arrangement according to Claim 1 or 2, in which
the MOS transistors have different threshold voltages depending on information stored in the respective memory cell.

4. Memory cell arrangement according to Claim 1 or 2, in which
the MOS transistors have a gate dielectric (8, 12) made of a material having traps.

5. Memory cell arrangement according to Claim 4, in which
the MOS transistors comprise, as gate dielectric (8, 12), a dielectric multiple layer having at least one layer which has an increased charge carrier capture cross-section compared with at least one further layer.

6. Memory cell arrangement according to Claim 5, in which
the layer having an increased charge carrier capture cross-section comprises at least one of the substances Si₃N₄, Ta₂O₅, Al₂O₃, or TiO₂, and the further layer comprises at least one of the substances SiO₂, Si₃N₄ or Al₂O₂.

7. Memory cell arrangement according to Claim 4, in which
the MOS transistors comprise, as gate dielectric (8, 12), a dielectric layer having included impurity atoms, the included impurity atoms having an increased charge carrier capture cross-section compared with the dielectric layer.

8. Memory cell arrangement according to Claim 7, in which the
dielectric layer comprises SiO₂, and the included impurity atoms contain at least one of the elements W, Pt, Cr, Ni, Pd, Si or Ir.

9. Method for the production of a memory cell arrangement, in which
- a plurality of strip-like trenches (5) which essentially run in parallel are etched in a main area (2) of a semiconductor substrate (1), and
- planar MOS transistors are formed in each case on the bottom of the trenches (5) and on the main area (2) between adjacent trenches (5),
**characterized in that**
- the planar MOS transistors arranged on the bottom of the trenches (5) and on the main area between adjacent trenches (5) are in each case interconnected in series, by the source/drain regions (14a, 14b) of adjacent planar MOS transistors each being formed as a coherent, doped region,
- vertical MOS transistors are formed on the side walls of the trenches (5),
- the two source/drain regions (14a, 14b) of each vertical MOS transistor are in each case formed as a coherent region with one of the source/drain regions (14a) of one of the planar MOS transistors on the main area (2) of the substrate (1) and with one of the source/drain regions (14b) of the planar MOS transistors on the bottom of the trenches (5), and
- an insulation structure (7), which suppresses the formation of conductive channels between adjacent MOS transistors, is formed between each two adjacent vertical MOS transistors which are arranged on the same side wall.

10. Method according to Claim 9, in which
respective doped regions are formed in the respective side wall in order to form the insulation structure (7).

11. Method according to Claim 9 or 10, in which
after the formation of a gate dielectric (12) for the planar MOS transistors, a plurality of first word lines (13) are formed, which run transversely with respect to the trenches (5) and comprise the gate electrodes of the planar MOS transistors, and an ion implantation is carried out in order to form the source/drain regions (14a, 14b), the first word lines (13) having a masking action.

12. Method according to one of Claims 9 to 11, in which,
after the formation of a gate dielectric (8) for the vertical MOS transistors, second word lines are formed by the formation of a conductive layer having essentially conformal edge covering and anisotropic etching back of the conductive layer in each trench (5), which second word lines are each arranged along a side wall of the trench (5) and comprise the gate electrodes of the vertical MOS transistors arranged along this side wall.

13. Method according to one of Claims 9 to 12, in which
the MOS transistors are produced with different threshold voltages depending on the stored information.

14. Method according to one of Claims 9 to 12, in which
the gate dielectric (8, 12) of the MOS transistors is formed from a material having traps.

15. Method according to Claim 14, in which
the gate dielectric (8, 12) is formed as a dielectric multiple layer having at least one layer which has an increased charge carrier capture cross-section compared with at least one further layer.

16. Method according to Claim 14, in which
the gate dielectric (8, 12) is formed as a dielectric layer having included impurity atoms, the included impurity atoms having an increased charge carrier capture cross-section compared with the dielectric layer.

## Revendications

1. Système de cellules de mémoire, dans lequel
- il est prévu, sur une surface (2) principale d'un substrat (1) semi-conducteur, une pluralité de cellules de mémoire qui comprennent respectivement au moins un transistor MOS,
- des premières cellules de mémoire comprennent des transistors MOS planaires qui sont disposés en lignes parallèles,
- dans le substrat (1) semi-conducteur, il est prévu des sillons (5) en forme de bandes sensiblement parallèles, qui s'étendent parallèlement aux lignes,
- les lignes sont disposées en alternance au fond des sillons (5) et sur la surface (2) principale entre des sillons (5) voisins et
- il est prévu une pluralité de premières lignes (13) de mots qui s'étendent transversalement aux sillons (5) et qui sont reliées à des électrodes de grille de transistors MOS planaires,
**caractérisé en ce que**
- des transistors MOS planaires disposés dans une ligne sont branchés en série,
- les zones (14a, 14b) de source/drain reliées entre elles de transistors MOS planaires voisins le long d'une ligne sont constituées sous la forme d'une zone dopée d'un seul tenant,
- des deuxièmes cellules de mémoire comprennent des transistors MOS verticaux par rapport à la surface (2) principale, qui sont réalisés respectivement sur les parois latérales des sillons (5),
- les deux zones (14a, 14b) de source/drain des transistors MOS verticaux sont constituées respectivement par l'une des zones (14a) de source/drain de l'un des transistors MOS planaires sur la surface (2) principale du substrat (1) semi-conducteur et par l'une des zones (14b) de source/drain des transistors MOS planaires au fond des sillons (5) sous la forme d'une zone dopée d'un seul tenant,
- il est prévu une pluralité de deuxièmes lignes (9) de mots qui sont disposées respectivement par paires dans l'un des sillons (5),
- les électrodes de grille des transistors MOS verticaux disposés le long de l'une des parois latérales des sillons (5) sont reliées à l'une des deuxièmes lignes (9) de mots et
- il est prévu, entre respectivement deux transistors MOS verticaux voisins qui sont disposés sur la même paroi latérale, une structure (7) d'isolement, qui supprime la constitution de canaux conducteurs entre des transistors MOS voisins.

2. Système de cellules de mémoire suivant la revendication 1, dans lequel les structures (7) d'isolement sont constituées respectivement sous la forme de zones dopées dans la paroi latérale respective.

3. Système de cellules de mémoire suivant la revendication 1 ou 2, dans lequel les transistors MOS ont, suivant l'information mémorisée dans la cellule de mémoire respective, des tensions de seuil différentes.

4. Système de cellules de mémoire suivant la revendication 1 ou 2, dans lequel les transistors MOS ont un diélectrique (8, 12) de grille en un matériau ayant des points de piégeage.

5. Système de cellules de mémoire suivant la revendication 4, dans lequel les transistors MOS comprennent, comme diélectrique (8, 12) de grille, une couche diélectrique stratifiée ayant au moins une couche qui, par rapport à au moins une autre couche, a une section de capture des porteurs de charge qui est plus grande.

6. Système de cellules de mémoire suivant la revendication 5, dans lequel la couche ayant une section de capture de porteurs de charge qui est plus grande comprend au moins l'une des substances Si₃N₄, Ta₂O₅, Al₂O₃ ou TiO₂ et l'autre couche au moins l'une des substances SiO₂, Si₃N₄ ou Al₂O₃.

7. Système de cellules de mémoire suivant la revendication 4, dans lequel les transistors MOS comprennent, comme diélectrique (8, 12) de grille, une couche diélectrique à atomes étrangers incorporés, les atomes étrangers incorporés ayant par rapport à la couche diélectrique une section de capture de porteurs de charge qui est plus grande.

8. Système de cellules de mémoire suivant la revendication 7, dans lequel la couche diélectrique comprend du SiO₂ et les atomes étrangers incorporés comprennent au moins l'un des éléments W, Pt, Cr, Ni, Pd, Si ou Ir.

9. Procédé de production d'un système de cellules de mémoire, dans lequel
- on ménage par attaque dans une surface (2) principale d'un substrat (1) semi-conducteur plusieurs sillons (5) en forme de bandes sensiblement parallèles et
- on forme des transistors MOS planaires respectivement au fond des sillons (5) et sur la surface (2) principale entre des sillons (5) voisins,
**caractérisé en ce que**
- on branche respectivement en série les transistors MOS planaires disposés au fond des sillons (5) ainsi que sur la surface principale entre des sillons (5) voisins en constituant les zones (14a, 14b) de source/drain de transistors MOS planaires voisins respectivement sous la forme d'une zone dopée d'un seul tenant,
- on forme des transistors MOS verticaux sur les parois latérales des sillons (5),
- on constitue sous la forme d'une zone d'un seul tenant les deux zones (14a, 14b) de source/drain de chaque transistor MOS vertical respectivement par l'une des zones (14a) de source/drain de l'un des transistors MOS planaires sur la surface (2) principale du substrat (1) et par l'une des zones (14b) de source/drain des transistors MOS planaires au fond des sillons (5) et
- on forme entre deux transistors MOS verticaux voisins qui sont disposés sur la même paroi latérale une structure (7) d'isolement, qui supprime la formation de canaux conducteurs entre des transistors MOS voisins.

10. Procédé suivant la revendication 9, dans lequel, pour former la structure (7) d'isolement, on forme des zones dopées respectivement dans chaque paroi latérale.

11. Procédé suivant la revendication 9 ou 10, dans lequel, après la formation d'un diélectrique (12) de grille pour les transistors MOS planaires, on forme plusieurs premières lignes (13) de mots qui s'étendent transversalement aux sillons (5) et qui comprennent les électrodes de grille des transistors MOS planaires, et on effectue une implantation d'ions pour former les zones (14a, 14b) de source/drain, les premières lignes (13) de mots agissant comme des masques.

12. Procédé suivant l'une des revendications 9 à 11, dans lequel, après la formation d'un diélectrique (8) de grille pour les transistors MOS verticaux, on forme, en formant une couche conductrice à recouvrement d'arête sensiblement conforme et par attaque en retour anisotrope de la couche conductrice, dans chaque sillon (5) des deuxièmes lignes de mots qui sont disposées respectivement le long d'une paroi latérale du sillon (5) et qui comprennent les électrodes de grille des transistors (MOS) verticaux disposés le long de cette paroi latérale.

13. Procédé suivant l'une des revendications 9 à 12, dans lequel on produit les transistors MOS suivant l'information mémorisée en leur donnant des tensions de seuil différentes.

14. Procédé suivant l'une des revendications 9 à 12, dans lequel on forme le diélectrique (8, 12) de grille des transistors MOS en un matériau ayant des points de piégeage.

15. Procédé suivant la revendication 14, dans lequel on forme le diélectrique (8, 12) de grille sous la forme d'une couche diélectrique stratifiée ayant au moins une couche qui, par rapport à au moins une autre couche, a une section de capture des porteurs de charge qui est plus grande.

16. Procédé suivant la revendication 14, dans lequel on forme le diélectrique (8, 12) de grille sous la forme d'une couche diélectrique ayant des atomes étrangers incorporés, les atomes étrangers incorporés ayant, par rapport à la couche diélectrique, une section de capture des porteurs de charge qui est plus grande.
